# EUROPÄISCHE PATENTSCHRIFT

(11) **EP 1 767 662 B1**
(45) Veröffentlichungstag und Bekanntmachung des Hinweises auf die Patenterteilung: **16.12.2009**
(21) Anmeldenummer: 06119083.1
(22) Anmeldetag: 17.08.2006
(51) Int. Cl.: C23C 16/26, C23C 16/02

(54) **Verschleißfeste Beschichtung und Verfahren zur Herstellung derselben**
Wear resistant coating and process of its manufacture
Revêtement résistant à l'usure et procédé pour sa fabrication

(30) Priorität: 10.09.2005 DE 102005043108
(43) Veröffentlichungstag der Anmeldung: 28.03.2007
(73) Patentinhaber: Schaeffler KG, 91074 Herzogenaurach (DE); ixetic Hückeswagen GmbH, 42499 Hückeswagen (DE)
(72) Erfinder: Hosenfeldt, Tim Matthias, 90419 Nürnberg (DE); Kramer, Martin, 42499 Hückeswagen (DE); Freiburg, Alexander, 59846 Sundern (DE)

(56) Entgegenhaltungen:
- EP-A- 0 887 122
- EP-A- 1 510 692
- EP-A1- 1 657 323
- WO-A-02/072908
- WO-A-03/064720
- US-A- 5 947 710
- US-A1- 2005 069 709

## Beschreibung

Die vorliegende Erfindung bezieht sich auf eine verschleißfeste Beschichtung auf vorbestimmten Flächen von einem reibenden Verschleiß ausgesetzten Maschinenteilen, welche aus einem Sintermaterial bestehen, und auf ein Verfahren zur Herstellung einer derartigen verschleißfesten Beschichtung, insbesondere für aus einem Sintermaterial bestehende Maschinenteile in Kraftstofffördereinheiten.

Obwohl auf beliebige aus einem Sintermaterial bestehende Maschinenteile anwendbar, werden die vorliegende Erfindung sowie die ihr zugrunde liegende Problematik in Bezug auf Maschinenteile aus einem Sintermaterial für Kraftstofffördereinheiten, insbesondere anhand einer Hubscheibe, näher erläutert.

Es sind der Anmelderin Kraftstofffördereinheiten bekannt, welche beispielsweise bei einer 4-, 5- und 10-Zylinder-Tandempumpe der LuK-Automobiltechnik auf dem sogenannten Sperrflügelprinzip basieren. Bei diesem Prinzip findet eine Hubscheibe Verwendung, welche in einer Mittelplatte der Fördereinheit drehbar angeordnet ist, und sich über bestimmte Kontaktflächen der Hubscheibe in Anlage mit einer zugeordneten Gegenflächen der Mittelplatte befindet. Sowohl die Hubscheibe als auch die Mittelplatte sind aus Kostengründen vorzugsweise aus einem Sintermaterial hergestellt. Aufgrund der auftretenden Reibkontaktstellen zwischen der Hubscheibe und der Mittelplatte tritt an der Mittelplatte der Fördereinheit, verstärkt bei den 5- und 10-Zylinderpumpen, ein radial auftretender Materialverschleiß an den entsprechenden Kontaktflächen auf.

Diesen Verschleiß, d. h. die bei Dauerbeanspruchung der sich berührenden Partnern auftretenden Abnutzungserscheinungen, die allgemein eine unerwünschte Veränderung der Oberfläche durch Lostrennen kleinster Teilchen in Folge mechanischer bzw. tribologischer Ursachen bewirken, hat man dadurch zu mindern versucht, dass man die beteiligten Partner thermo-chemischen Behandlungen zur Erzielung bestimmter Eigenschaften unterworfen hat. Beispielsweise wurden die Kontaktflächen carbonitriert, nitrocarburiert, nitriert und/oder oxidiert.

An diesem Ansatz hat sich jedoch die Tatsache als nachteilig herausgestellt, dass trotz der verwendeten thermo-chemischen Prozesse, beispielsweise trotz eines Plasma-Nitrocarburierens der Mittelplatte, insbesondere bei einer 5- und 10-Zylinderfördereinheit radial weiterhin ein zu hoher, wenn auch verringerter Verschleißwiderstand auftritt. Ein Plasma-Nitrocarburier-Prozess der Hubscheibe birgt zudem mehrere Probleme in sich. Um den Belastungen standzuhalten, die auf die Hubscheibe wirken, wird diese nach dem Sinterprozess endogasschroffabgekühlt und bei etwa 200°C bis 250°C angelassen. Das Plasma-Nitrocarburieren findet bei einer Temperatur von in etwa 550°C bis 590°C statt. Dabei geht die ursprüngliche Härte der Hubscheibe verloren und diese muss an den belasteten Stellen zusätzlich induktivgehärtet werden. Bei einem Beschichten mit einer Verfahrenstemperatur, welche oberhalb der Anlasstemperatur des Grundmaterials bzw. des Hubscheibmaterials liegt, ändert sich das Gefüge der Hubscheibe und somit auch die gefertigten Maße derselben, was aus konstruktionstechnischen Gründen äußerst nachteilig und unerwünscht ist.

Ferner sind aus einem Sintermaterial hergestellte Bauteile sehr porös und enthalten daher Fremdstoffe, wie beispielsweise Kühlschmiermittel oder dergleichen. Diese Fremdstoffe müssen vor dem Plasma-Nitrocarburieren entfernt, um den Beschichtungsprozess durch das Ausgasen der Stoffe nicht zu stören. Somit ist ein weiterer Verfahrensschritt nachteilig erforderlich. Außerdem ist aufgrund der sehr unebenen Sintermetalloberfläche der Hubscheibe die aufgebrachte Verschleißschicht bei einem Nitrocarborieren nicht sehr gleichmäßig ausgeprägt, so dass es zu Abplatzungen der Verschleißschicht führen kann. Ferner kann es an den Werkstoffkanten auch zu Kantenaufwürfen kommen.

Ferner besteht ein Nachteil von thermo-chemischen Prozessen, wie beispielsweise bei einem Plasma-Nitrocarburieren, darin, dass etwaige vorgesehene Verbindungsschichten mit einer relativ hohen Härte auf der Hubscheibe mit einer relativ geringen Materialhärte, die durch die Vorwärmebehandlung entstanden ist, lediglich einen geringen Halt besitzen, so dass die etwaige Verbindungsschicht sich in unerwünschter Weise von der Hubscheibe lösen kann.

Ferner ist der Anmelderin der Ansatz bekannt, die Kontaktflächen der Bauteile mittels eines Mangan-Phosphatierungsprozesses zu behandeln oder mit einer Gleitlackschicht zu beschichten, oder galvanische Schichten auf den Kontaktflächen aufzubringen. Die Reibung kann zwar reduziert werden, der Verschleißwiderstand solcher Schichten ist aber gering, so dass die Schicht abgetragen wird. Bei galvanischen Schichten ist zudem die Umweltbelastung als nachteiliger Faktor anzusehen.

Ferner ist der Anmelderin der Ansatz bekannt, die verwendeten Bauteilpartner aus einem Hartmetall oder einem Schnellarbeitstahl herzustellen. An diesem Ansatz hat sich jedoch die Tatsache als nachteilig herausgestellt, dass diese Materialien eine äußerst hohe Masse aufweisen und fertigungstechnisch lediglich sehr aufwändig zu bearbeiten sind.

Es ist der Anmelderin auch bekannt, Schichten mit hohen Oberflächenhärten, wie beispielsweise TiN, CrN, (Ti, Al)N oder dergleichen, mittels PVD- oder (PA)CVD-Verfahren auf der Hubscheibe aufzubringen. An diesem Ansatz hat sich jedoch die Tatsache als nachteilig herausgestellt, dass aufgrund der auftretenden geringerer Verschleißwiderstand bewerkstelligt werden kann. Bei galvanischen Schichten ist zudem die Umweltbelastung als nachteiliger Faktor anzusehen.

Ferner ist der Anmelderin der Ansatz bekannt, die verwendeten Bauteilpartner aus einem Hartmetall oder einem Schnellarbeitstahl herzustellen. An diesem Ansatz hat sich jedoch die Tatsache als nachteilig herausgestellt, dass diese Materialien eine äußerst hohe Masse aufweisen und fertigungstechnisch lediglich sehr aufwändig zu bearbeiten sind.

Es ist der Anmelderin auch bekannt, Schichten mit hohen Oberflächenhärten, wie beispielsweise TiN, CrN, (Ti, Al)N oder dergleichen, mittels PVD- oder (PA)CVD-Verfahren auf der Hubscheibe aufzubringen. An diesem Ansatz hat sich jedoch die Tatsache als nachteilig herausgestellt, dass aufgrund der auftretenden höheren Reibung zwischen den Bauteilpartnern und der vergrößerten Oberflächenhärte der Hubscheibe der Verschleiß des Gegenkörpers, d. h. der Mittelplatte der Fördereinheit nachteilig vergrößert wird, so dass die Lebensdauer der gesamten Fördereinheit verringert wird.

Bisher ist es nicht gelungen, Sintermaterialien mittels PVD- oder (PA)CVD-Verfahren mit haftfesten Schichten zu versehen, da zum Einen das Grundmaterial aufgrund der Poren und der geringen Härte eine schlechte Stützwirkung der notwendigerweise harten Verschleißschutzschicht bietet, und zum Zweiten die Poren des Sintermaterials im Vakuumbeschichtungsprozess fertigungsbedingte, zumeist ölige Rückstände ausgasen, wodurch der Beschichtungsprozess gestört wird bzw. keine Anbindung der Verschleißschutzschicht an das Grundmaterial erreicht werden kann.

Die Druckschrift WO 03/064720 beschreibt ein Verfahren zur Abscheidung von metallfreien amorphen wasserstoffhaltigen Kohlenstoffschichten auf Substrate mittels eines Sputterns von Targets. Als Target wird ein reines Kohlenstoff-Target, insbesondere ein Graphit-Target eingesetzt und mit einer negativen Gleichspannung vorgespannt.

Die Druckschrift EP-A-1 510 692 beschreibt einen Kühlschrankkompressor und ein Reibungssteuerungs-Verfahren dafür.

Die Druckschrift WO 02/072908 beschreibt Rotationsflüssigkeits-Lagerbeschichtungen, sowie Verfahren zum Herstellen derselben.

Die Druckschrift EP-A-0 887 122 beschreibt ein Wasser-Hochdruckreinigungsgerät mit einem Gehäuse, mit einer vorzugsweise elektromotorischen Antriebseinrichtung mit Antriebswelle und mit einer von der Antriebseinrichtung angetriebenen Hochdruckpumpe für Reinigungswasser bzw. eine Wasser/Reinigungsmittel-Mischung.

Die Druckschrift US 5947710 offenbart einen Drehkolbenverdichter mit einer amorphen Kohlenstoffbeschichtung.

Die Druckschrift US 2005/0069709 offenbart eine Verbundstruktur, in der auf eine mehrlagige Zwischenschicht eine Diamantbeschichtung aufgetragen ist.

Die Druckschrift EP 1657323 offenbart ein Gleitelement mit einer amorphen Kohlenstoffbeschichtung.

Somit weist die vorliegende Erfindung gegenüber dem Stand der Technik den Vorteil auf, dass die Verschleißbeständigkeit beispielsweise im Kontaktbereich zwischen Hubscheibe und Mittelplatte bei einer Kraftstofffördereinheit gegenüber dem Stand der Technik erhöht wird. Ferner wird eine Reduzierung der Reibung im Gleitkontakt zur Mittelplatte gegenüber dem Stand der Technik gewährleistet.

Ein weiterer Vorteil besteht darin, dass die Eigenschaften der Hubscheibe bzw. des Sintermaterials bezüglich des Gefüges sowie die funktionsbedingten Bauteiltoleranzen bei einer Aufbringung der erfindungsgemäßen verschleißfesten Beschichtung vorteilhaft nicht verändert werden. Somit kann durch die Verwendung der erfindungsgemäßen verschleißfesten Beschichtung auf den kostengünstigen Sinterwerkstoff als Unterbau zurückgegriffen werden, so dass das Bauteil im Sinterverfahren wettbewerbsfähig herstellbar ist. Die auf dem Sintermaterial aufgebrachte Beschichtung stellt eine haftfeste und die Bauteileigenschaften nicht verändernde verschleißfeste Beschichtung dar, welche die Lebensdauer der Reibpartner und somit der Fördereinheit vorteilhaft verlängert.

In den Unteransprüchen finden sich vorteilhafte Ausgestaltungen und Verbesserungen der im Anspruch 1 angegebenen verschleißfesten Beschichtung und des im Anspruch 10 angegebenen Verfahrens zur Herstellung einer derartigen Beschichtung.

Gemäß einer bevorzugten Weiterbildung weist die amorphe Kohlenwasserstoffschicht einen Wasserstoffanteil von maximal 20 Atom-% auf. Dadurch weist die vorbestimmte Fläche des Maschinenteils bzw. der Hubscheibe eine geringe Adhäsionsneigung zum metallischen Gegenkörper, d.h. der Mittelplatte, einen hohen abrasiven Verschleißwiderstand, eine hohe chemische Beständigkeit, hohe mechanische Festigkeiten und hohe Härte/E-Modul-Verhältnisse auf. Ein höherer Wasserstoffanteil könnte zu unerwünschten Verbindungen mit Schmiermitteln oder dergleichen führen.

Vorzugsweise weist die amorphe Kohlenwasserstoffschicht prozessbedingte Verunreinigungen, beispielsweise O- oder Ar-Atome, Metalle oder dergleichen, von weniger als 1 Atom-% auf.

Die Gesamtbeschichtung besitzt gemäß einem weiteren bevorzugten Ausführungsbeispiel eine Dicke von etwa 2,0 µm bis 5,0 µm, wobei die amorphe Kohlenwasserstoffschicht vorzugsweise eine Dicke von 1,0 µm bis 4,0 µm besitzt. Durch derartige Schichtdicken ändern sich die Abmessungen der Maschinenteile in einem so geringen Maße, dass keine Nachbearbeitung notwendig ist und die eingestellte Oberflächenstruktur bzw. Topographie beibehalten wird.

Gemäß einer weiteren bevorzugten Weiterbildung ist zwischen der vorbestimmten Fläche des Maschinenteils und der amorphen Kohlenwasserstoffschicht mindestens eine Zwischenschicht und mindestens eine Haftvermittlungsschicht vorgesehen. Die mindestens eine Zwischenschicht ist dabei als metallhaltige Kohlenwasserstoffschicht ausgebildet, wobei die Metallkomponenten aus W, Hf, oder eine Kombination der vorgenannten Komponenten bestehen. Die Zwischenschicht weist vorteilhaft eine Dicke von etwa 0,5 µm bis 2,0 µm auf. Die mindestens eine Haftvermittlungsschicht besteht aus Boriden, der Übergangsmetalle. Vorzugsweise besitzt die Haftvermittlungsschicht eine Dicke von etwa 0,1 µm bis 0,5 µm.

Gemäß einem weiteren bevorzugten Ausführungsbeispiel wird die amorphe Kohlenwasserstoffschicht mittels eines PVD- oder eines (PA)CVD-Verfahrens auf der vorbestimmten Fläche des Maschinenteils abgeschieden. Eine Abscheidung der mindestens einen Zwischenschicht und/oder der mindestens einen Haftvermittlungsschicht erfolgt vorzugsweise mittels eines PVD-Verfahrens.

Es wird vorzugsweise keine thermische und/oder mechanische Nachbearbeitung der abgeschiedenen amorphen Kohlenwasserstoffschicht durchgeführt.

Die vorbestimmte Fläche des Maschinenteils besteht aus einem gehärteten Sinterstahl. Somit kann auf den kostengünstigen Sinterstahl als Unterbau zurückgegriffen werden und das Maschinenteil im Sinterverfahren wettbewerbsfähig hergestellt werden.

Vorzugsweise wird vor einer Abscheidung der amorphen Kohlenwasserstoffschicht die vorbestimmte Fläche des Maschinenteils einer Reinigung unterzogen, beispielsweise einer Badreinigung in verschiedenen Reinigungsbädern mit einem anschließenden Ausgasungsvorgang in einem Reinigungsofen oder dergleichen. Dadurch wird eine dauerhafte Anhaftung der Beschichtung an dem Grundkörper gewährleistet.

Nach einem weiteren bevorzugten Ausführungsbeispiel werden die amorphe Kohlenwasserstoffschicht, die mindestens eine Zwischenschicht und/oder die mindestens eine Haftvermittlungsschicht bei jeweils einer Beschichtungstemperatur abgeschieden, welche jeweils kleiner sind als die Anlasstemperatur des Maschinenteils. Vorteilhaft liegt auch die Ausgasungstemperatur eines etwaigen Ausgasungsvorgangs unterhalb der Anlasstemperatur des Maschinenteils. Dadurch erfährt das Maschinenteil keinen Härteverlust und keinen Verzug.

Beispielhafte Verwendungen der verschleißfesten Beschichtung sind die Kontaktflächen einer Hubscheibe zu einer Mittelplatte einer Dieselfördereinheit einer Brennkraftmaschine, wobei die Hubscheibe aus einem Sintermaterial hergestellt ist. Jedoch können mit einer derartigen verschleißfesten Beschichtung auch aus einem Sintermaterial bestehende Mittelplatten, Ventiltriebkomponenten, wie beispielsweise Tassenstößel, hydraulische Abstütz- und Einsteckelemente, Wälzlagerkomponenten, Steuerkolben, Ausrücklager, Kolbenbolzen, Lagerbuchsen, Linearführungen, oder dergleichen, versehen werden.

Die Erfindung wird im folgenden anhand von Ausführungsbeispielen unter Bezugnahme auf die beiliegenden Figuren der Zeichnung näher erläutert. Von den Figuren zeigen:
- Figur 1: eine Draufsicht auf eine Dieselfördereinheit gemäß einem Ausführungsbeispiel der vorliegenden Erfindung;
- Figur 2: eine Querschnittsansicht der Dieselfördereinheit aus Fig. 1 entlang der Schnittlinie A-A; und
- Figur 3: eine vergrößerte Ansicht der auf der Kontaktfläche der Hubscheibe zur Mittelscheibe abgeschiedenen verschleißfesten Besichtung gemäß einem bevorzugten Ausführungsbeispiel der vorliegenden Erfindung.

In den Figuren bezeichnen die selben Bezugszeichen gleiche oder funktionsgleiche Komponenten, soweit nichts Gegenteiliges angegeben ist.

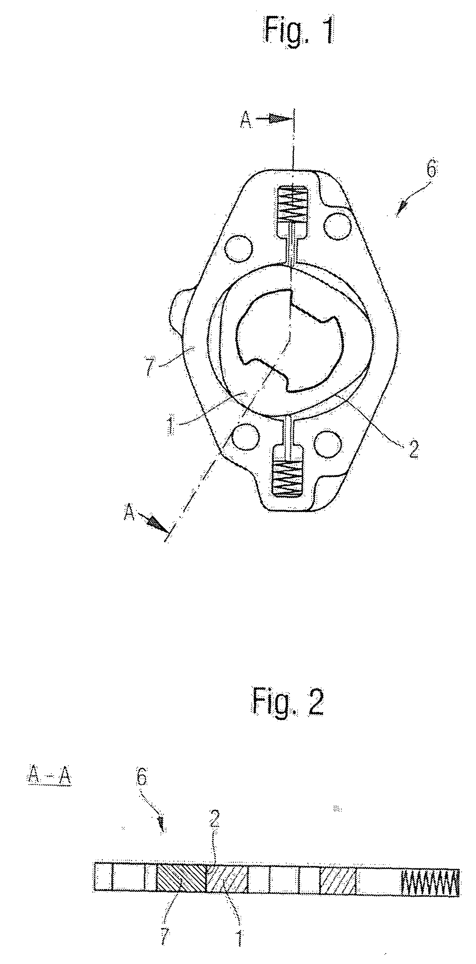

Figur 1 illustriert eine Draufsicht auf eine Dieselfördereinheit 6 und Figur 2 eine Querschnittansicht entlang der Linie A-A der Dieselfördereinheit 6 aus Figur 1 gemäß einem bevorzugten Ausführungsbeispiel der vorliegenden Erfindung. Die Dieselfördereinheit 6 weist eine Mittelplatte 7 auf, in welcher sich eine Hubscheibe 1 unter Bildung von Reibkontaktflächen zwischen der Hubscheibe 1 und der Mittelplatte 7 zum Betreiben eines Tandempumpensystems, beispielsweise basierend auf einem Sperrflügelprinzip, dreht. Dabei kommt es insbesondere an den Kontaktflächen zwischen der Hubscheibe 1 und der Mittelplatte 7 der Fördereinheit 6 zu einem Materialverschleiß aufgrund der auftretenden Reibungskräfte.

Es ist wünschenswert, diese Kontaktflächen 2 der Hubscheibe 1 mit einem Verschleißschutz bzw. einer verschleißfesten Beschichtung zu versehen, um den Verschleißwiderstand der Hubscheibe 1 für eine verlängerte Lebensdauer derselben zu erhöhen.

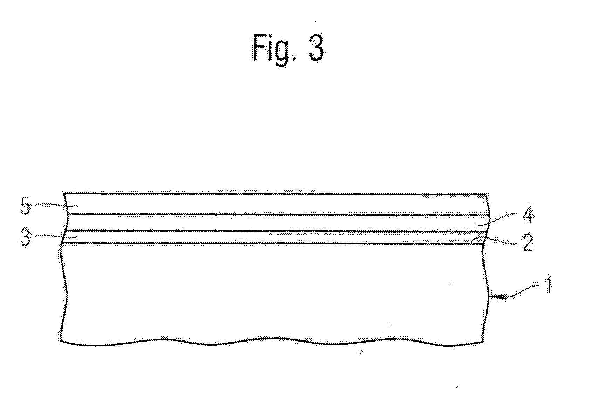

Fig. 3 illustriert eine vergrößerte Darstellung eines Ausschnitts der Hubscheibe 1 aus Fig. 1. Wie in Fig. 3 ersichtlich ist, ist auf einer vorbestimmten Fläche 2 der Hubscheibe 1 eine verschleißfeste Beschichtung 3, 4, 5 für eine Erhöhung des Verschleißwiderstandes sowie für eine Reduzierung des Reibmomentes vorgesehen.

Gemäß einem bevorzugten Ausführungsbeispiel der vorliegenden Erfindung wird als Grundkörper der Hubscheibe 1 ein metallischer Grundkörper aus einem Sintermaterial, insbesondere aus einem gehärtetem Sinterstahl, verwendet. Durch Verwendung derartiger Grundkörpermaterialien kann auf gängige Fertigungstechnologien zurückgegriffen und der Grundkörper in einem Sinterverfahren wettbewerbsfähig hergestellt werden.

Wie in Fig. 2 ferner illustriert ist, wird auf eine vorbestimmte Fläche bzw. auf die Kontaktfläche 2 der Hubscheibe 1 zur Mittelplatte 7 eine Haftvermittlungsschicht 3 aufgebracht. Die Haftvermittlungsschicht 3 kann beispielsweise mittels eines PVD-Verfahrens (Physical Vapour Deposition) auf die vorbestimmte Fläche 2 der Hubscheibe 1 abgeschieden werden. Die Haftvermittlungsschicht 3 besteht aus Boriden, der Übergangsmetalle und weist vorzugsweise eine Dicke von 0,1 µm bis 0,5 µm auf. Die Haftvermittlungsschicht 3 dient einer verbesserten Anbringung bzw. einer verbesserten Vernetzung der Atome einer anschließend aufzubringenden Zwischensicht oder Funktionsschicht am Grundkörper 1. Die Dicke der Haftvermittlungsschicht 3 ist in Abhängigkeit der verwendeten Zwischenschicht 4 bzw. der Kundenwünsche und -anforderungen auszuwählen.

Gemäß dem vorliegenden Ausführungsbeispiel wird anschließend eine Zwischenschicht 4, wie in Fig. 3 ersichtlich ist, auf der Haftvermittlungsschicht 3 mittels beispielsweise ebenfalls eines PVD-Verfahrens abgeschieden. Die Zwischenschicht 4 wird als metallhaltige Kohlenwasserstoffschicht (Me-C:H) aufgebracht werden, wobei die Metallkomponente W, Hf, einzeln oder zu mehreren auftreten kann. Die Zwischenschicht 4 weist beispielsweise eine Dicke von etwa 0,5 µm bis 2,0 µm auf und dient einer verbesserten Anbringung der Funktionsschicht auf der Haftvermittlungsschicht 3 bzw. im Falle eines Fehlens der Haftvermittlungsschicht 3 für eine verbesserte Anbringung der Funktionsschicht auf dem Grundkörper 1 in physikalisch mechanischer und chemischer Hinsicht. Die Dicke der Zwischenschicht 4 ist dabei wiederum an Zusammensetzungen der verwendeten Schichten und an die jeweiligen Anforderungen anzupassen.

Wie in Fig. 3 ferner dargestellt ist, wird anschließend die eigentliche Funktionsschicht 5 auf der Zwischenschicht 4 abgeschieden. Vorzugsweise wird ein spezieller Übergang von der Zwischenschicht 4 zu der Funktionsschicht 5 entwickelt, welcher eine optimale Anbindung der Funktionsschicht 5 sicherstellt und möglichst geringe Spannungen in das Schichtsystem bzw. in die kritische Schnittstelle zwischen dem porigen Grundmaterial und dem Schichtsystem induziert, wodurch ein Abplatzen sowohl in kohäsiver als auch in adhäsiver Form vermieden wird.

Die Funktionsschicht 5 ist als amorphe Kohlenwasserstoffschicht (a-C:H) ausgebildet und wird vorzugsweise mittels eines PVD- und/oder (PA)CVD-Verfahrens (Plasma Assisted Chemical Vapour Deposition) auf einer vorgesehenen Schicht, gemäß dem vorliegenden Ausführungsbeispiel auf der Zwischenschicht 4, abgeschieden.

Bei einem PVD-Verfahren wird ein Ausgangsmaterial, beispielsweise Graphit, derart erhitzt, dass ein Strahl hochenergetischer Kohlenstoffionen aus dem Graphit emittiert und in Richtung der zu beschichtenden Oberfläche geführt wird. Dabei kann die zu beschichtende Oberfläche einmal oder mehrmals in einer Prozesskammer an dem hochenergetischen lonenstrahl zum Bilden einer oder mehrerer Schichten vorbeigeführt werden.

Bei einem (PA)CVD-Verfahren wird unter Zuhilfenahme eines Plasmas ein Gasgemisch in die Prozesskammer eingebracht, in welche die zu beschichtenden Materialteile vorhanden sind. Bei vorbestimmten Temperaturen reagieren die eingebrachten Gase chemisch miteinander und führen zu einer dünnen Kondensschicht auf den Oberflächen der zu beschichtenden Materialteile.

Die Aufgabe des gesamten Schichtsystems, bestehend aus dem Grundkörper 1, der Haftvermittlungsschicht 3, der Zwischenschicht 4 sowie der amorphen Kohlenwasserstoffschicht 5, besteht darin, die Reibung zwischen dieser Beschichtung und einem Gegenkörper, beispielsweise der Mittelplatte 7 der Krafstofffördereinheit 6, zu reduzieren und die Lebensdauer der beschichteten Hubscheibe 1 sowie die des Gegenkörpers zu erhöhen.

Die amorphe Kohlenwasserstoffschicht 5 weist daher vorzugsweise einen Wasserstoffanteil von maximal 20 Atom-% auf, wodurch eine geringe Adhäsionsneigung zum metallischen Gegenkörper, ein hoher abrasiver Verschleißwiderstand, eine hohe chemische Beständigkeit, hohe mechanische Festigkeiten und hohe Härte/E-Modul-Verhältnisse gewährleistet werden. Ansonsten besteht die amorphe Kohlenwasserstoffschicht 5 aus sp²- und sp³-hybridisiertem Kohlenstoff, wobei vorzugsweise prozessbedingte Verunreinigungen von weniger als 1 Atom-% vorgesehen sind.

Die amorphe Kohlenwasserstoffschicht 5 weist vorzugsweise eine Schichtdicke von etwa 1,0 µm bis 4,0 µm auf. Die gesamte Dicke der Beschichtung, bestehend aus den einzelnen Schichten 3, 4 und 5, beträgt vorzugsweise etwa 2,0 µm bis 5,0 µm. Durch eine solche Dicke der Gesamtbeschichtung ändern sich die Abmessungen des Maschinenteils bzw. der Hubscheibe 1 in einem derartig geringen Maße, dass keine Nachbearbeitung notwendig und die eingestellte Oberflächenstruktur bzw. Topographie beibehalten wird. Die tribologischen Aufgaben übernimmt die Oberfläche der Beschichtung, die durch die eingestellte Struktur das Mischreibungsgebiet reduziert und aufgrund der reibungsarmen Beschichtung die Reibkraft und folglich die Oberflächenbeanspruchungen reduziert. Die mechanischen Aufgaben hingegen übernimmt das Schichtsystem im Verbund mit dem Grundkörper.

Als Gegenkörper, im vorliegenden Fall beispielsweise die Mittelplatte 7 der Fördereinheit 6, können vorzugsweise im Sinne des Leichtbaus und der Kosteneinsparung Eisen-Kohlenstoff-Legierungen realisiert werden. Darüber hinaus sind niedrig viskose und niedrig additivierte Öle einsetzbar. Ferner kann eine Minimalschmierung bzw. ein erhöhter Ölwechselintervall realisiert werden.

Vorzugsweise wird vor einer Beschichtung des Grundkörpers die vorbestimmte Fläche 2 desselben gereinigt, beispielsweise mittels einer Badreinigung in verschiedenen Reinigungsbädern mit einem anschließenden Ausgasungsvorgang in einem Reinigungsofen oder dergleichen. Dadurch wird die Anhafteigenschaft der Beschichtung an dem Grundkörper vorteilhaft verbessert.

Die Beschichtungstemperatur der einzelnen Beschichtungsvorgänge liegt bei in etwa 200°C und die Ausgasungstemperatur für den Ausgasungsvorgang des Grundkörpers bei in etwa 240°C. Somit liegen diese Temperaturbereiche unterhalb der Anlasstemperatur des Sintermaterials der Hubscheibe 1. Dadurch erfährt die Hubscheibe 1 vorteilhaft weder einen Härteverlust noch einen Verzug.

Somit schafft die vorliegende Erfindung eine verschleißfeste Beschichtung und ein Verfahren zur Herstellung einer derartigen verschleißfesten Beschichtung, wobei auf den kostengünstigen Sinterwerkstoff als Unterbau zurückgegriffen werden kann, welcher aber ohne der erfindungsgemäßen Beschichtung der tribologischen Beanspruchung nicht standhalten würde. Aufgrund der notwendigen komplexen Teilegeometrie ist fertigungsbedingt somit vorteilhaft ein Sinterwerkstoff mit einer erfindungsgemäßen Beschichtung einsetzbar, so dass das Bauteil im Sinterverfahren wettbewerbsfähig hergestellt werden kann. Die Beschichtung kann aufgrund der geringen Gesamtschichtdicke sehr gleichmäßig und ohne nennenswerten Rauheitszuwachs aufgebracht werden. Dadurch ist das Beschichten ohne Vorhaltemaß und ohne kostenintensive Nachbearbeitung möglich.

Durch die oben beschriebene Beschichtung entsteht ein tribologisches System, welches durch die eingestellte Struktur das Mischreibungsgebiet reduziert und aufgrund der reibungsarmen Beschichtung die Reibkraft und folglich die Oberflächenbeanspruchung reduziert sowie den Verschleißwiderstand erhöht.

Neben einer Beschichtung von Kontaktflächen von Hubscheiben in Fördereinheiten können selbstverständlich auch andere Maschinenteile, beispielsweise zusätzlich der Gegenkörper, d. h. die Mittelplatte, andere Ventiltriebbauteile, wie beispielsweise Tassenstößel, hydraulische Abstütz- und Einsteckelemente, Wälzlagerkomponenten, Steuerkolben, Ausrücklager, Kolbenbolzen, Lagerbuchsen, Linearführungen, oder dergleichen, erfindungsgemäß beschichtet werden.

Obwohl die vorliegende Erfindung anhand bevorzugter Ausführungsbeispiele vorstehend beschrieben wurde, ist sie darauf nicht beschränkt, sondern auf vielfältige Weise modifizierbar.

### Bezugszeichenliste

- 1: Maschinenteil/Hubscheibe
- 2: vorbestimmte Fläche des Maschinenteils/Kontaktfläche der Hubscheibe zur Mittelplatte
- 3: Haftvermittlungsschicht
- 4: Zwischenschicht
- 5: amorphe Kohlenwasserstoffschicht/Funktionsschicht
- 6: Kraftstofffördereinheit
- 7: Mittelplatte

## Patentansprüche

1. Verschleißfeste Beschichtung auf vorbestimmten Flächen (2) von einem reibenden Verschleiß ausgesetzten Maschinenteilen (1) aus einem gehärteten Sinterstahl für insbesondere Kraftstofffördereinheiten, bestehend aus mindestens einer auf die vorbestimmte Fläche (2) des Maschinenteils (1) aufgebrachten metallfreien amorphen Kohlenwasserstoffschicht (5) mit sp²- und sp³-hybridisiertem Kohlenstoff für eine Reibungsreduzierung und für eine Erhöhung des Verschleißwiderstandes der vorbestimmten Fläche (2) des Maschinenteils (1), **dadurch gekennzeichnet, dass** zwischen der vorbestimmten Fläche (2) des Maschinenteils (1) und der amorphen Kohlenwasserstoffschicht (5) mindestens eine Haftvermittlungsschicht (3) und mindestens eine Zwischenschicht (4) vorgesehen ist, wobei die mindestens eine Zwischenschicht (4) als metallhaltige Kohlenwasserstoffschicht ausgebildet ist, und die Metallkomponenten der metallhaltigen Kohlenwasserstoffschicht (4) aus W, Hf oder einer Kombination der vorgenannten Komponenten bestehen, und dass die mindestens eine Haftvermittlungsschicht (3) aus Boriden der Übergangsmetalle besteht.

2. Verschleißfeste Beschichtung nach Anspruch 1, **dadurch gekennzeichnet, dass** die amorphe Kohlenwasserstoffschicht (5) einen Wasserstoffanteil von maximal 20 Atom-% aufweist.

3. Verschleißfeste Beschichtung nach Anspruch 1 oder 2, **dadurch gekennzeichnet, dass** die amorphe Kohlenwasserstoffschicht prozessbedingte Verunreinigungen von weniger als 1 Atom-% aufweist.

4. Verschleißfeste Beschichtung nach wenigstens einem der vorhergehenden Ansprüche, **dadurch gekennzeichnet, dass** die amorphe Kohlenwasserstoffschicht (5) eine Dicke von etwa 1,0 µm bis 4,0 µm aufweist.

5. Verschleißfeste Beschichtung nach Anspruch 1, **dadurch gekennzeichnet, dass** die mindestens eine Zwischenschicht (4) eine Dicke von etwa 0,5 µm bis 2,0 µm aufweist.

6. Verschleißfeste Beschichtung nach Anspruch 1, **dadurch gekennzeichnet, dass** die Haftvermittlungsschicht (3) eine Dicke von etwa 0,1 µm bis 0,5 µm aufweist.

7. Verschleißfeste Beschichtung nach wenigstens einem der vorhergehenden Ansprüche, **dadurch gekennzeichnet, dass** die vorbestimmte Fläche (2) des Maschinenteils (1) aus einem gehärteten Sinterstahl besteht.

8. Verwendung der Beschichtung (3, 4, 5) nach wenigstens einem der vorhergehenden Ansprüche als Kontaktfläche (2) einer aus einem Sintermaterial hergestellte Hubscheibe (1) zu einer Mittelplatte einer Pumpeneinrichtung einer Kraftstofffördereinheit.

9. Verwendung der Beschichtung (3, 4, 5) nach wenigstens einem der Ansprüche 1 bis 7 auf vorbestimmten Flächen (2) von aus einem Sintermaterial bestehenden Mittelplatten (7) von Kraftstofffördereinheiten (6), Ventiltriebkomponenten, wie beispielsweise Tassenstößel, Nockenwellen, hydraulischen Abstütz- und Einsteckelementen, Wälzlagerkomponenten, Steuerkolben, Ausrücklagern, Kolbenbolzen, Lagerbuchsen, Linearführungen, oder dergleichen.

10. Verfahren zur Herstellung einer verschleißfesten Beschichtung auf vorbestimmten Flächen (2) von einem reibenden Verschleiß ausgesetzten Maschinenteilen (1) aus einem gehärteten Sinterstahl für insbesondere Kraftstofffördereinheiten mit folgendem Verfahrensschritt:
Aufbringen mindestens einer metallfreien amorphen Kohlenwasserstoffschicht (5) mit sp²- und sp³-hybridisiertem Kohlenstoff auf die vorbestimmte Fläche (2) des Maschinenteils (1) für eine Reibungsreduzierung und eine Erhöhung des Verschleißwiderstandes der vorbestimmten Fläche (2) des Maschinenteils (1), **dadurch gekennzeichnet, dass** zwischen der vorbestimmten Fläche (2) des Maschinenteils (1) und der amorphen Kohlenwasserstoffschicht (5) mindestens eine Haftvermittlungsschicht (3) und mindestens eine Zwischenschicht (4) ausgebildet wird, wobei die mindestens eine Zwischenschicht (4) als metallhaltige Kohlenwasserstoffschicht ausgebildet wird, und die Metallkomponenten der metallhaltigen Kohlenwasserstoffschicht (4) aus W, Hf oder einer Kombination der vorgenannten Komponenten bestehen, und dass die mindestens eine Haftvermittlungsschicht (3) aus Boriden der Übergangsmetalle ausgebildet wird.

11. Verfahren nach Anspruch 10, **dadurch gekennzeichnet, dass** die amorphe Kohlenwasserstoffschicht (5) mittels eines PVD- und/oder eines (PA)CVD-Verfahrens auf die vorbestimmte Fläche (2) des Maschinenteils (1) abgeschieden wird.

12. Verfahren nach Anspruch 10 oder 11, **dadurch gekennzeichnet, dass** die amorphe Kohlenwasserstoffschicht (5) mit einem Wasserstoffanteil von maximal 20 Atom-% ausgebildet wird.

13. Verfahren nach wenigstens einem der Ansprüche 10 bis 12, **dadurch gekennzeichnet, dass** die amorphe Kohlenwasserstoffschicht (5) mit prozessbedingten Verunreinigungen von weniger als 1 Atom-% ausgebildet wird.

14. Verfahren nach wenigstens einem der Ansprüche 10 bis 14, **dadurch gekennzeichnet, dass** die amorphe Kohlenwasserstoffschicht (5) mit einer Dicke von etwa 1,0 µm bis 4,0 µm ausgebildet wird.

15. Verfahren nach wenigstens einem der Ansprüche 10 bis 14, **dadurch gekennzeichnet, dass** vor einer Abscheidung der amorphen Kohlenwasserstoffschicht (5) die vorbestimmte Fläche (2) des Maschinenteils (1) einer Reinigung, beispielsweise einer Badreinigung in verschiedenen Reinigungsbädern mit einem anschließenden Ausgasungsvorgang in einem Reinigungsofen oder dergleichen, unterzogen wird.

16. Verfahren nach Anspruch 10, **dadurch gekennzeichnet, dass** die mindestens eine Zwischenschicht (4) mit einer Dicke von etwa 0,5 µm bis 2,0 µm ausgebildet wird.

17. Verfahren nach wenigstens einem der Ansprüche 10, **dadurch gekennzeichnet, dass** die mindestens eine Haftvermittlungsschicht (3) mit einer Dicke von etwa 0,1 µm bis 0,5 µm ausgebildet wird.

18. Verfahren nach wenigstens einem der Ansprüche 10 bis 17 **dadurch gekennzeichnet, dass** die amorphe Kohlenwasserstoffschicht (5), die mindestens eine Zwischenschicht (4) und/oder die mindestens eine Haftvermittlungsschicht (3) bei jeweils einer Beschichtungstemperatur abgeschieden werden, welche jeweils kleiner sind als die Anlasstemperatur des Maschinenteils (1).

## Claims

1. Wear-resistant coating on predetermined surfaces (2) of machine or engine parts (1) consisting of a hardened sintered steel which are exposed to frictional wear, for fuel feed units in particular, comprising at least one metal-free, amorphous hydrocarbon layer (5) with sp²- and sp³- hybridized carbon applied to the predetermined surface (2) of the machine or engine part (1) for reducing friction and increasing the wear resistance of the predetermined surface (2) of the machine or engine part (1), **characterized in that** at least one adhesion promoting layer (3) and at least one intermediate layer (4) are provided between the predetermined surface (2) of the machine or engine part (1) and the amorphous hydrocarbon layer (5), wherein the at least one intermediate layer (4) is formed as a metal-containing hydrocarbon layer, and the metal components of the metal-containing hydrocarbon layer (4) consist of W, Hf or a combination of the abovementioned components, and **in that** the at least one adhesion promoting layer (3) consists of borides of the transition metals.

2. Wear-resistant coating according to Claim 1, **characterized in that** the amorphous hydrocarbon layer (5) has a hydrogen content of at most 20 atomic %.

3. Wear-resistant coating according to Claim 1 or 2, **characterized in that** the amorphous hydrocarbon layer has process-related impurities of less than 1 atomic %.

4. Wear-resistant coating according to at least one of the preceding claims, **characterized in that** the amorphous hydrocarbon layer (5) has a thickness of approximately 1.0 µm to 4.0 µm.

5. Wear-resistant coating according to Claim 1, **characterized in that** the at least one intermediate layer (4) has a thickness of approximately 0.5 µm to 2.0 µm.

6. Wear-resistant coating according to Claim 1, **characterized in that** the adhesion promoting layer (3) has a thickness of approximately 0.1 µm to 0.5 µm.

7. Wear-resistant coating according to at least one of the preceding claims, **characterized in that** the predetermined surface (2) of the machine or engine part (1) consists of a hardened sintered steel.

8. Use of the coating (3, 4, 5) according to at least one of the preceding claims as a contact surface (2) of a cam plate (1), produced from a sintered material, with respect to a middle plate of a pump device of a fuel feed unit.

9. Use of the coating (3, 4, 5) according to at least one of Claims 1 to 7 on predetermined surfaces (2) of middle plates (7), consisting of a sintered material, of fuel feed units (6), valve gear components, such as for example bucket tappets, camshafts, hydraulic supporting and insertion elements, rolling bearing components, control pistons, release bearings, piston pins, bearing bushes, linear guides or the like.

10. Process for producing a wear-resistant coating on predetermined surfaces (2) of machine or engine parts (1) consisting of a hardened sintered steel which are exposed to frictional wear, for fuel feed units in particular, with the following process step:
applying at least one metal-free, amorphous hydrocarbon layer (5) with sp²- and sp³-hybridized carbon to the predetermined surface (2) of the machine or engine part (1) for reducing friction and increasing the wear resistance of the predetermined surface (2) of the machine or engine part (1), **characterized in that** at least one adhesion promoting layer (3) and at least one intermediate layer (4) are formed between the predetermined surface (2) of the machine or engine part (1) and the amorphous hydrocarbon layer (5), wherein the at least one intermediate layer (4) is formed as a metal-containing hydrocarbon layer, and the metal components of the metal-containing hydrocarbon layer (4) consist of W, Hf or a combination of the abovementioned components, and **in that** the at least one adhesion promoting layer (3) is formed from borides of the transition metals.

11. Process according to Claim 10, **characterized in that** the amorphous hydrocarbon layer (5) is deposited onto the predetermined surface (2) of the machine or engine part (1) by means of a PVD and/or a (PA)CVD process.

12. Process according to Claim 10 or 11, **characterized in that** the amorphous hydrocarbon layer (5) is formed with a hydrogen content of at most 20 atomic %.

13. Process according to at least one of Claims 10 to 12, **characterized in that** the amorphous hydrocarbon layer (5) is formed with process-related impurities of less than 1 atomic %.

14. Process according to at least one of Claims 10 to 13, **characterized in that** the amorphous hydrocarbon layer (5) is formed with a thickness of approximately 1.0 µm to 4.0 µm.

15. Process according to at least one of Claims 10 to 14, **characterized in that**, before depositing of the amorphous hydrocarbon layer (5), the predetermined surface (2) of the machine or engine part (1) undergoes cleaning, for example bath cleaning in various cleaning baths, with a subsequent outgassing operation in a cleaning oven or the like.

16. Process according to Claim 10, **characterized in that** the at least one intermediate layer (4) is formed with a thickness of approximately 0.5 µm to 2.0 µm.

17. Process according to at least one of Claims 10 to 16, **characterized in that** the at least one adhesion promoting layer (3) is formed with a thickness of approximately 0.1 µm to 0.5 µm.

18. Process according to at least one of Claims 10 to 17, **characterized in that** the amorphous hydrocarbon layer (5), the at least one intermediate layer (4) and/or the at least one adhesion promoting layer (3) are deposited at in each case a coating temperature respectively less than the tempering temperature of the machine or engine part (1).

## Revendications

1. Revêtement résistant à l'usure sur des surfaces (2) prédéterminées de pièces (1) de machine soumises à une usure par frottement en acier fritté durci, en particulier pour des unités de transport de carburant, constitué par au moins une couche d'hydrocarbure (5) amorphe exempte de métaux avec du carbone hybridé en sp² et sp³ appliquée sur la surface prédéterminée (2) de la pièce (1) de machine pour une réduction du frottement et pour une augmentation de la résistance à l'usure de la surface prédéterminée (2) de la pièce (1) de machine, **caractérisé en ce qu'**on a prévu entre la surface prédéterminée (2) de la pièce (1) de machine et la couche d'hydrocarbure (5) amorphe au moins une couche de promoteur d'adhérence (3) et au moins une couche intermédiaire (4), où ladite au moins une couche intermédiaire (4) est réalisée sous forme de couche d'hydrocarbure contenant des métaux et les composants métalliques de la couche d'hydrocarbure (4) contenant des métaux sont constitués par W, Hf ou une combinaison des composants susmentionnés et **en ce que** ladite au moins une couche de promoteur d'adhérence (3) est constituée par des borures des métaux de transition.

2. Revêtement résistant à l'usure selon la revendication 1, **caractérisé en ce que** la couche d'hydrocarbure (5) amorphe présente une proportion d'hydrogène d'au maximum 20% en atome.

3. Revêtement résistant à l'usure selon la revendication 1 ou 2, **caractérisé en ce que** la couche d'hydrocarbure amorphe présente des impuretés dues au processus à raison de moins de 1% en atome.

4. Revêtement résistant à l'usure selon au moins l'une quelconque des revendications précédentes, **caractérisé en ce que** la couche d'hydrocarbure (5) amorphe présente une épaisseur d'environ 1,0 µm à 4,0 µm.

5. Revêtement résistant à l'usure selon la revendication 1, **caractérisé en ce que** ladite au moins une couche intermédiaire (4) présente une épaisseur d'environ 0,5 µm à 2,0 µm.

6. Revêtement résistant à l'usure selon la revendication 1, **caractérisé en ce que** la couche de promoteur d'adhérence (3) présente une épaisseur d'environ 0,1 µm à 0,5 µm.

7. Revêtement résistant à l'usure selon au moins l'une quelconque des revendications précédentes, **caractérisé en ce que** la surface prédéterminée (2) de la pièce (1) de machine est constituée par un acier fritté durci.

8. Utilisation du revêtement (3, 4, 5) selon au moins l'une quelconque des revendications précédentes comme surface de contact (2) d'un disque à cames (1) réalisé en matériau fritté avec un plateau central d'un dispositif à pompe d'une unité de transport de carburant.

9. Utilisation du revêtement (3, 4, 5) selon au moins l'une quelconque des revendications 1 à 7 sur des surfaces prédéterminées (2) de plateaux centraux (7) constitués par un matériau fritté d'unités de transport de carburant (6), de composants de commande de soupapes, tels que par exemple des poussoirs creux, des arbres à came, des éléments support et emboîtés hydrauliques, des composants de paliers à roulement, des pistons de commande, des butées d'embrayage, des axes de piston, des bagues de palier, des commandes linéaires ou analogues.

10. Procédé pour la réalisation d'un revêtement résistant à l'usure sur des surfaces prédéterminées (2) de pièces (1) de machine soumises à une usure par frottement en acier fritté durci, en particulier pour des unités de transport de carburant présentant l'étape de procédé suivante:
application d'au moins une couche d'hydrocarbure (5) amorphe exempte de métaux avec du carbone hybridé en sp² et sp³ sur la surface prédéterminée (2) de la pièce (1) de machine pour une réduction du frottement et pour une augmentation de la résistance à l'usure de la surface prédéterminée (2) de la pièce (1) de machine, **caractérisée en ce qu'**on forme entre la surface prédéterminée (2) de la pièce (1) de machine et la couche d'hydrocarbure (5) amorphe au moins une couche de promoteur d'adhérence (3) et au moins une couche intermédiaire (4), où ladite au moins une couche intermédiaire (4) est réalisée sous forme de couche d'hydrocarbure contenant des métaux et les composants métalliques de la couche d'hydrocarbure contenant des métaux (4) sont constitués par W, Hf ou une combinaison des composants susmentionnés et **en ce que** ladite au moins une couche de promoteur d'adhérence (3) est réalisée à partir de borures des métaux de transition.

11. Procédé selon la revendication 10, **caractérisé en ce que** la couche d'hydrocarbure (5) amorphe est déposée au moyen d'un procédé PVD et/ou (PA)CVD sur la surface prédéterminée (2) de la pièce (1) de machine.

12. Procédé selon la revendication 10 ou 11, **caractérisé en ce que** la couche d'hydrocarbure (5) amorphe est réalisée avec une proportion d'hydrogène d'au maximum 20% en atome.

13. Procédé selon au moins l'une quelconque des revendications 10 à 12, **caractérisé en ce que** la couche d'hydrocarbure (5) amorphe est réalisée avec des impuretés dues au processus inférieures à 1% en atome.

14. Procédé selon au moins l'une quelconque des revendications 10 à 13, **caractérisé en ce que** la couche d'hydrocarbure (5) amorphe est réalisée avec une épaisseur d'environ 1,0 µm à 4,0 µm.

15. Procédé selon au moins l'une quelconque des revendications 10 à 14, **caractérisé en ce qu'**avant le dépôt de la couche d'hydrocarbure (5) amorphe, la surface prédéterminée (2) de la pièce (1) de machine est soumise à un nettoyage, par exemple un nettoyage dans différents bains de nettoyage avec un processus de dégazage consécutif dans un four de nettoyage ou analogue.

16. Procédé selon la revendication 10, **caractérisé en ce que** ladite au moins une couche intermédiaire (4) est réalisée avec une épaisseur d'environ 0,5 µm à 2,0 µm.

17. Procédé selon au moins l'une quelconque des revendications 10 à 16, **caractérisé en ce que** ladite au moins une couche de promoteur d'adhérence (3) est réalisée avec une épaisseur d'environ 0,1 µm à 0,5 µm.

18. Procédé selon au moins l'une quelconque des revendications 10 à 17, **caractérisé en ce que** la couche d'hydrocarbure (5) amorphe, ladite au moins une couche intermédiaire (4) et/ou ladite au moins une couche de promoteur d'adhérence (3) sont déposées à chaque fois à une température de revêtement qui est à chaque fois inférieure à la température de revenu de la pièce (1) de machine.
